# EUROPÄISCHE PATENTSCHRIFT

(11) **EP 3 482 941 B1**
(45) Veröffentlichungstag und Bekanntmachung des Hinweises auf die Patenterteilung: **07.04.2021**
(21) Anmeldenummer: 18206249.7
(22) Anmeldetag: 14.11.2018
(51) Int. Cl.: B41F 15/20, B41F 15/26, B25B 11/00, B41F 3/51, H01L 21/687, B41F 3/78

(54) **HALTEVORRICHTUNG ZUM HALTEN VON SUBSTRATEN WIE LEITERPLATTEN UND DERGLEICHEN**
HOLDING DEVICE FOR HOLDING SUBSTRATES LIKE CIRCUIT BOARDS AND SUCH LIKE
DISPOSITIF DE RETENUE PERMETTANT DE RETENIR DES SUBSTRATS COMME CARTES DE CIRCUIT IMPRIMÉ ET ANALOGUES

(30) Priorität: 14.11.2017 DE 102017220296; 22.01.2018 DE 102018200945
(43) Veröffentlichungstag der Anmeldung: 15.05.2019
(73) Patentinhaber: Notion Systems GmbH, 68723 Schwetzingen (DE)
(72) Erfinder: Münkel, Jens, 68766 Hockenheim (DE); Schönefeld, Jan, 69181 Leimen (DE); Doran, Michael, 69221 Dossenheim (DE)
(74) Vertreter: Patent- und Rechtsanwälte Ullrich & Naumann

(56) Entgegenhaltungen:
- WO-A1-2010/116360
- DE-A1- 4 030 113
- US-A1- 2010 013 169

## Beschreibung

Die Erfindung betrifft eine Haltevorrichtung zum Halten von Substraten wie Leiterplatten, Metallblechen, Folien oder dergleichen, umfassend eine Ansaugfläche, wobei die Ansaugfläche eine Vielzahl von Ansaugdüsen aufweist und wobei die Ansaugdüsen mit einem Unterdruck gegenüber dem Umgebungsdruck mittels einer Unterdruckbereitstellungseinrichtung zur Bereitstellung einer Haltekraft für ein oder mehrere Substrate beaufschlagbar sind.

Die Erfindung betrifft ebenfalls ein Verfahren zum Halten von Substraten wie Leiterplatten, Metallblechen, Folien oder dergleichen, wobei ein oder mehrere Substrate mittels einer Ansaugfläche gehalten werden, wobei die Ansaugfläche eine Vielzahl von Ansaugdüsen aufweist, und wobei die Ansaugdüsen mit einem Unterdruck gegenüber dem Umgebungsdruck zur Bereitstellung einer Haltekraft für ein oder mehrere Substrate beaufschlagt werden.

Die Erfindung betrifft weiterhin eine Ink-Jet-Druckvorrichtung.

Leiterplatten, Metallbleche, Folien, Papier oder dergleichen - im Folgenden allgemein als Substrate bezeichnet - können je nach Anwendungsbereich und Herstellungsart höchst unterschiedliche Steifigkeiten aufweisen. Diese reichen von starr bis hochflexibel. Darüber hinaus weisen Substrate häufig durchgehende Bohrungen bis hin zu großflächigen Öffnungen auf. So können beispielsweise Leiterplatten Bohrungen aufweisen, um diese mittels einer Schraubverbindung an einem Träger festzulegen.

Durch eine vorhergehende Bearbeitung oder durch deren Herstellungsprozess sind Substrate häufig nicht mehr planeben, sondern weisen Durchbiegungen in der Diagonale, gemessen als maximale Abweichung senkrecht zur Diagonale beim nicht durchgebogenen Substrat, von mehreren Prozent auf. Um diese nun weiter zu bearbeiten, ist es üblich, diese auf ebenen Bearbeitungstischen anzuordnen und temporär festzulegen, um ein Bearbeiten wie bspw. Bedrucken der Oberfläche der Substrate, ein Schneiden, Bohren, ein Bearbeiten mittels eines Lasers, ein Transportieren oder eine automatische optische Inspektion zu ermöglichen. Die Substrate müssen dabei während der Bearbeitung auf dem meist bewegbaren und ebenen Bearbeitungstisch sehr zuverlässig fixiert werden, um ein präzises und schnelles Bearbeiten zu ermöglichen. Hierzu werden in bekannter Weise die Substrate auf einer Ansaugfläche einer Saugplatte positioniert und mittels eines Unterdrucks bzw. Ansaugstroms auf dieser festgehalten bzw. festgelegt.

Ein Problem dabei ist, dass nicht von dem Substrat überdeckte Bereiche einer Ansaugfläche zu einem Zusammenbruch der Haltekraft führen können, mithin also das Substrat nicht mehr ordnungsgemäß auf dem Bearbeitungstisch für eine Bearbeitung festgelegt bzw. fixiert ist. Zur Lösung dieses Problems ist es bekannt geworden, nicht vom Substrat überdeckte Bereiche der Ansaugfläche und Bereiche von Öffnungen im Substrat abzudecken, beispielsweise abzukleben, um ein Zusammenbrechen der Haltekraft zu verhindern.

Zusätzlich ist es bekannt geworden, die Substrate mittels Halteelementen, beispielsweise in Form von über die Oberfläche überstehenden Pilzköpfen, Leisten oder dergleichen, an den Rändern durch Klemmen auf die Oberfläche des Bearbeitungstischs zu ziehen.

Ein Nachteil dabei ist, dass in aufwendiger Weise die Bereiche sowohl auf dem Bearbeitungstisch als auch die Öffnungen in den Substraten abgeklebt bzw. verdeckt werden müssen, was insbesondere bei großen Öffnungen oder bei einer großen Anzahl von kleineren Öffnungen äußerst zeitintensiv ist. Darüber hinaus müssen diese nach dem Prozessieren bzw. Bearbeiten des Substrats wieder aufwendig entfernt werden. Hierdurch besteht eine gewisse Wahrscheinlichkeit das prozessierte Substrat zu beschädigen. Darüber hinaus können Kleberückstände auf dem Ansaugtisch zurückbleiben, die vor einem Prozessieren eines weiteren Substrats aufwendig entfernt werden müssen. Ebenso können sich während des Prozessierens eines Substrats die entsprechenden Abdeckungen bzw. die Abklebungen lösen, was dazu führt, dass das Substrat in Folge falsch prozessiert und/oder die entsprechende Bearbeitungsvorrichtung beschädigt wird. Dadurch erhöhen sich insgesamt die Herstellungskosten und die Zuverlässigkeit bei der Bearbeitung von Substraten sinkt.

Dokument US 2010/013169 A1 offenbart eine Vorrichtung und ein Verfahren nach dem Oberbegriff von Anspruch 1 bzw. Anspruch 14.

Eine Aufgabe der vorliegenden Erfindung ist es daher, eine Haltevorrichtung und ein Verfahren zum Halten von Substraten wie Leiterplatten, Metallblechen, Folien oder dergleichen zur Verfügung zu stellen, die ein zuverlässiges Festlegen auch von Substraten mit vielen und/oder großen Öffnungen und/oder mit einer Durchbiegung in einfacher Weise ermöglicht. Eine weitere Aufgabe der vorliegenden Erfindung ist eine einfache, kostengünstige und flexible Haltervorrichtung zur Verfügung zu stellen, welche ein schnelleres bzw. effizienteres Bearbeiten von Substraten ermöglicht.

Die vorliegende Erfindung löst die Aufgabe bei einer Haltevorrichtung zum Halten von Substraten wie Leiterplatten, Metallblechen, Folien oder dergleichen, umfassend eine Ansaugfläche wobei die Ansaugfläche eine Vielzahl von Ansaugdüsen aufweist und wobei die Ansaugdüsen mit einem Unterdruck gegenüber dem Umgebungsdruck mittels einer Unterdruckbereitstellungseinrichtung zur Bereitstellung einer Haltekraft für ein oder mehrere Substrate beaufschlagbar sind, dadurch, dass die Unterdruckbereitstellungseinrichtung einen Unterdruck bereitstellt, derart, dass das Verhältnis aus kumuliertem Druckabfall aller Ansaugdüsen zu kumuliertem Druckabfall aller Ansaugdüsen und Zuleitungen der Ansaugdüsen bis zur Unterdruckbereitstellungseinrichtung größer als 25%, insbesondere größer als 35%, vorzugsweise größer als 40%.

Die vorliegende Erfindung löst die Aufgabe ebenfalls bei einem Verfahren zum Halten von Substraten wie Leiterplatten, Metallblechen, Folien oder dergleichen, wobei ein oder mehrere Substrate mittels einer Ansaugfläche gehalten werden, wobei die Ansaugfläche eine Vielzahl von Ansaugdüsen aufweist, und wobei die Ansaugdüsen mit einem Unterdruck gegenüber dem Umgebungsdruck zur Bereitstellung einer Haltekraft für ein oder mehrere Substrate beaufschlagt werden, dadurch, dass mittels der Unterdruckbereitstellungseinrichtung ein Unterdruck bereitgestellt wird, derart, dass das Verhältnis aus kumuliertem Druckabfall aller Ansaugdüsen zu kumuliertem Druckabfall aller Ansaugdüsen und Zuleitungen der Ansaugdüsen bis zur Unterdruckbereitstellungseinrichtung größer als 0,25% ist, insbesondere größer als 1%, vorzugsweise größer als 25%, insbesondere größer als 35%, vorzugsweise größer als 40%.

Die vorliegende Erfindung löst die Aufgabe ebenfalls mit einer Ink-Jet-Druckvorrichtung mit einer Haltevorrichtung gemäß einem der Ansprüche 1-19.

Mit anderen Worten: Um eine ausreichende Haltekraft für ein oder mehrere Substrate bereitzustellen, werden, auch im Fall, dass insbesondere eine oder mehrere oder alle bis auf eine Ansaugöffnung von einem oder mehreren Substraten nicht abgedeckt wird/werden, diejenigen Ansaugdüsen, welche abgedeckt sind, weiterhin mit einem merklichen Differenzdruck gegen den Umgebungsdruck beaufschlagt. Der Druckabfall entlang der unbedeckten Ansaugdüsen im Verhältnis zum Druckabfall bis zur Unterdruckbereitstellungseinrichtung ist dann derart dimensioniert, dass der Druckabfall an den Ansaugdüsen im Fall, dass alle Düsen unbedeckt sind, ausreichend hoch ist, um das oder die Substrate zuverlässig anzusaugen und festzuhalten. Der maximale Leckstrom durch unbedeckte Ansaugdüsen wird dadurch begrenzt. Je mehr Ansaugdüsen von einem oder mehreren Substraten überdeckt werden, desto größer wird das Verhältnis aus kumuliertem Druckabfall aller Ansaugdüsen zu kumuliertem Druckabfall aller Ansaugdüsen und Zuleitungen der Ansaugdüsen bis zur Unterdruckbereitstellungseinrichtung. Der kumulierte Druckabfall an den Ansaugdüsen kann dabei im Verhältnis zum Gesamtdruckabfall bis zur Unterdruckbereitstellungseinrichtung bspw. mehr als 1%, vorzugsweise mehr als 10%, insbesondere mehr als 50%, vorzugsweise mehr als 70% betragen.

Einer der damit erzielten Vorteile ist, dass zum Halten von Substraten mittels der Haltevorrichtung auf zusätzliche Halteelemente in Form von Pilzköpfen, Klemmleisten oder dergleichen verzichtet werden kann. Dies senkt zum einen den Zeitaufwand für die Bearbeitung; ein aufwendiges Betätigen der Halteelemente entfällt. Darüber hinaus werden Beschädigungen der Substrate durch die Halteelemente vermieden, sodass eine größere Substratfläche bearbeitet werden kann, was wiederum die Herstellungskosten für ein Substrat senkt. Ein weiterer Vorteil ist, dass das aufwändige Abkleben bzw. Abdecken offener Bereiche der Ansaugplatte und/oder des Substrats vermieden werden kann, was ein schnelleres Prozessieren verschiedener Substrate erleichtert. Ebenso wird die Genauigkeit bei der Bearbeitung von Substraten wesentlich gesteigert, da das Substrat zum einen äußerst zuverlässig fixiert werden kann, zum anderen auch Randbereiche zuverlässig bearbeitet werden können, da insbesondere die Halteelemente im Randbereich nicht einen Teil der Substratoberfläche überdecken. Hierdurch kann insbesondere beim Ink-Jet-Druck der Druckabstand verringert und die Druckgenauigkeit erhöht werden.

Weitere Merkmale, Vorteile und weitere Ausführungsformen der Erfindung sind im Folgenden beschrieben oder werden dadurch offenbar:
Gemäß einer vorteilhaften Weiterbildung weist zumindest eine der Ansaugdüsen eine Ansaugöffnung auf, derart, dass eine Querschnittsfläche der Ansaugöffnung größer ist als die Querschnittsfläche der Ansaugdüse. Auf dieser Weise wird die Zuverlässigkeit der Bereitstellung einer Haltekraft für Substrate wesentlich erhöht.

Gemäß einer vorteilhaften Weiterbildung ist das Verhältnis der Querschnittsfläche der Ansaugöffnungen und Querschnittfläche der Ansaugdüsen zwischen 0,01 und 10000, vorzugsweise zwischen 1 und 400, insbesondere zwischen 4 und 144, insbesondere zwischen 25 und 81, vorzugsweise zwischen 36 und 64. Auf diese Weise kann der maximale Leckstrom durch die Ansaugdüsen zuverlässig minimiert bzw. begrenzt werden.

Gemäß einer weiteren vorteilhaften Weiterbildung umfasst die Unterdruckbereitstellungseinrichtung eine Verteilungseinrichtung zum Verteilen eines Ansaugstroms auf die Ansaugdüsen umfasst. Damit kann auf zuverlässige Weise ein Ansaugstrom die Ansaugdüsen beaufschlagen.

Gemäß einer weiteren vorteilhaften Weiterbildung sind mittels der Verteilungseinrichtung mehrere Ansaugbereiche der Ansaugplatte definierbar und getrennt ansteuerbar. Einer der Vorteile ist, dass die Effizienz erhöht wird, da zum einen nicht benötigte Bereiche zum Ansaugen von Substraten einfach abgeschaltet werden können, zum anderen die Zuverlässigkeit der Haltevorrichtung insgesamt erhöht wird, da der Leckstrom durch Abschalten nicht benötigter Bereiche wesentlich vermindert werden kann.

Gemäß einer weiteren vorteilhaften Weiterbildung weist die Verteilungseinrichtung ein oder mehrere Zuleitungen zur Versorgung der Ansaugdüsen der Ansaugfläche oder von einem oder mehreren Ansaugbereichen auf, wobei für die Ansaugfläche oder für jeden Ansaugbereich das Verhältnis aus kumulierter Querschnittsfläche der jeweiligen Zuleitungen und kumulierter Querschnittsfläche der Ansaugdüsen in der Ansaugfläche oder in dem Ansaugbereich mindestens 0,3, vorzugsweise zwischen 1 und 20, insbesondere zwischen 1,5 und 6 beträgt. Damit wird eine zuverlässige Beaufschlagung der Ansaugdüsen mit dem Ansaugstrom sichergestellt. Hierbei können die Zuleitungen auch in verschiedenen Bereichen verschiedene Querschnitte und damit auch unterschiedliche kumulierte Querschnittsflächen aufweisen. Für das oben genannte Verhältnis können dann beispielsweise Leitungen in bzw. unterhalb der Ansaugplatte herangezogen werden und/oder die Zuleitungen zu diesen Leitungen ausgehend von der Unterdruckbereitstellungseinrichtung.

Gemäß einer weiteren vorteilhaften Weiterbildung weist die Verteilungseinrichtung Schaltventile zum Ansteuern verschiedener Ansaugbereiche auf. Damit können auf einfache und gleichzeitig zuverlässige Weise verschiedene Ansaugbereiche mit einem Ansaugstrom gesteuert werden.

Gemäß einer weiteren vorteilhaften Weiterbildung weist die Unterdruckbereitstellungseinrichtung eine Ansaugimpulseinrichtung auf, insbesondere welche strömungstechnisch zwischen einer Ansaugeinrichtung und der Verteilungseinrichtung angeordnet ist zur Bereitstellung eines ersten Ansaugimpulses. Vorteil hiervon ist, dass ein zeitlich begrenzter Unterdruckimpuls zum ersten Ansaugen von Substraten erzeugt werden kann, was die Festlegung von Substraten wesentlich erleichtert.

Gemäß einer weiteren vorteilhaften Weiterbildung weist die Ansaugimpulseinrichtung eine Unterdruckkammer auf. Damit kann auf zuverlässige und schnelle Weise ein erster Ansaugimpuls bereitgestellt werden.

Gemäß einer weiteren vorteilhaften Weiterbildung ist eine Unterdruckmesseinrichtung zur Messung und Regelung eines Unterdrucks des Ansaugstroms und/oder eine Durchflussmesseinrichtung zur Messung des Durchflusses durch die Zuleitungen angeordnet. Damit kann der Druck des Ansaugstroms ermittelt werden und gegebenenfalls nachgeregelt werden. Insgesamt wird damit eine noch zuverlässigere Festlegung von Substraten mittels der Haltevorrichtung ermöglicht.

Gemäß einer weiteren vorteilhaften Weiterbildung ist ein Unterdruck verschiedener Ansaugbereiche mittels der Unterdruckmesseinrichtung und/oder mittels der Durchflussmesseinrichtung messbar und regelbar. Damit lässt sich auch entsprechend eine Regelung des Unterdrucks für verschiedene Bereiche vornehmen, was insgesamt die Zuverlässigkeit der Haltevorrichtung für Substrate erhöht.

Gemäß einer weiteren vorteilhaften Weiterbildung ist eine Erkennungseinrichtung angeordnet, zur Erkennung von Leerbereichen der Ansaugplatte, die substratfrei sind. Damit kann eine voll automatisierte Erkennung und Abschaltung von nicht benötigten Ansaugbereichen der Haltevorrichtung vorgenommen werden, was das Prozessieren von verschiedenen Substraten wesentlich vereinfacht.

Gemäß einer weiteren vorteilhaften Weiterbildung umfasst die Erkennungseinrichtung optische und/oder akustische Erkennungsmittel. Damit können auf flexible und gleichzeitig zuverlässige Weise Leerbereiche erkannt werden. Optische Erkennungsmittel können beispielsweise Kameras, optische Sensoren oder dergleichen umfassen. Akustische Erkennungsmittel können dabei beispielsweise bereitgestellt werden durch Ultraschallsensoren oder dergleichen. Leerbereiche können auch durch eine Leckstrommessung und/oder eine Unterdruckmessung erkannt werden. Diese Leckstrommessung kann auch mit optischen Erkennungsverfahren kombiniert werden, um die Zuverlässigkeit und die Genauigkeit der Erkennung von Leerbereichen zu erhöhen.

Gemäß einer weiteren vorteilhaften Weiterbildung sind die Ansaugdüsen und/oder die Ansaugöffnungen regelmäßig, insbesondere periodisch, verteilt angeordnet. Dies ermöglicht eine einfache Herstellung und gleichzeitig ein gleichmäßiges Festhalten von Substraten. Das Raster von Ansaugöffnungen und/oder -düsen kann dabei bspw. zwischen 0,5 mm und 50 mm betragen. Neben der regelmäßigen Ausbildung und/oder Anordnung sind ebenso ein linear ansteigendes oder fallendes Raster möglich.

Gemäß einer weiteren vorteilhaften Weiterbildung sind im Wesentlichen benachbarte Reihen von Ansaugdüsen und/oder Ansaugöffnungen versetzt zueinander angeordnet und/oder weisen eine andere Ausbildung. Einer der damit erzielten Vorteile ist, dass dadurch die Flexibilität beim Halten von ggf. unregelmäßig geformten Substraten oder bei einem ungenauen Auflegen von Substraten erhöht wird: Substrate mit unregelmäßigen Kanten in Bezug auf die Anordnung der Ansaugdüsen und/oder -Öffnungen können trotzdem zuverlässig durch die Haltevorrichtung gehalten bzw. festgelegt werden.

Gemäß einer weiteren vorteilhaften Weiterbildung weisen im Randbereich der Ansaugfläche die Ansaugdüsen und/oder die Ansaugöffnungen eine andere Anordnungsdichte und/oder Ausbildung auf. Damit ist ein besonders zuverlässiges Festlegen von Substraten im Randbereich der Ansaugfläche möglich.

Gemäß einer weiteren vorteilhaften Weiterbildung weisen verschiedene Ansaugbereiche unterschiedliche angeordnete und/oder ausgebildete Ansaugdüsen und/oder Ansaugöffnungen auf. Damit wird die Flexibilität beim Festlegen von Substraten weiter erhöht, da Substrate verschiedenster Form zuverlässig gehalten werden können.

Gemäß einer weiteren vorteilhaften Weiterbildung sind die verschiedenen Ansaugbereiche zum Halten verschieden fester und/oder verschieden dicker Substrate ausgebildet. Damit lassen sich auf besonders zuverlässige Weise Substrate verschiedener Festigkeit bzgl. Durchbiegen festlegen. So können Leiterplatten ebenso wie Folien zuverlässig und ggf. gleichzeitig auf der Ansaugfläche festgelegt werden.

Weitere wichtige Merkmale und Vorteile der Erfindung ergeben sich aus den Unteransprüchen, aus den Zeichnungen, und aus dazugehöriger Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungen und Ausführungsformen der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile oder Elemente beziehen.

Dabei zeigt
- Figur 1: einen Teil einer Haltevorrichtung mit Blickrichtung von oben gemäß einer Ausführungsform der vorliegenden Erfindung;
- Figur 2: einen Teil eines Querschnitts durch die Haltevorrichtung gemäß einer Ausführungsform der vorliegenden Erfindung; und
- Figur 3: eine Detailansicht des Querschnitts der Ausführungsform gemäß Figur 2.

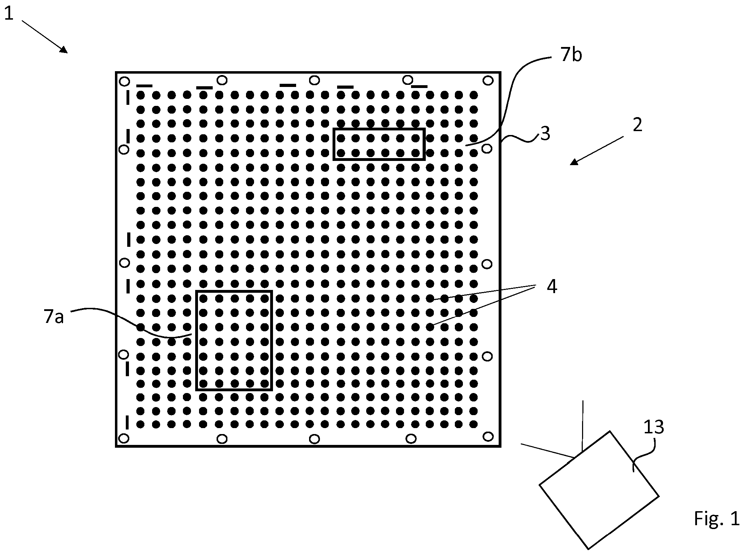

Figur 1 zeigt einen Teil einer Haltevorrichtung mit Blickrichtung von oben gemäß einer Ausführungsform der vorliegenden Erfindung.

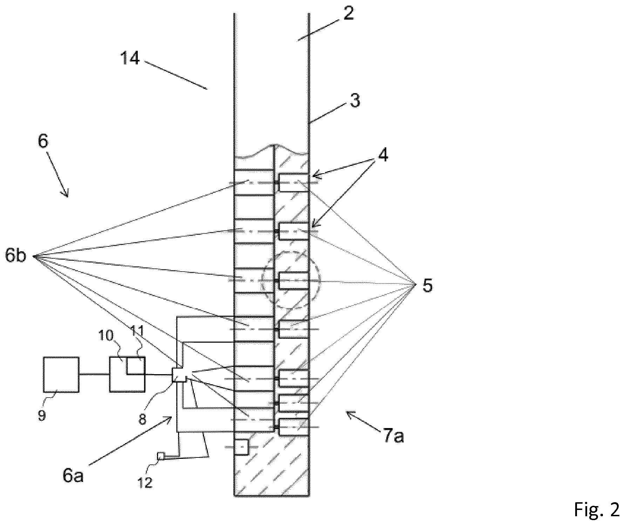

In Figur 1 ist eine Haltevorrichtung 1 mit Ansicht von oben gezeigt. Die Haltevorrichtung 1 weist eine rechtwinklige Vakuum-Ansaugplatte 2 auf, die eine Ansaugfläche 3 für ein Substrat aufweist. Die Vakuum-Ansaugplatte kann dabei auch kreisrund, elliptisch oder auch jede andere Form aufweisen. In der Ansaugfläche 3 sind Ansaugöffnungen 4 angeordnet, die periodisch bzw. gleichmäßig über die Ansaugfläche 3 verteilt angeordnet sind. Auf der Oberseite der Vakuum-Ansaugplatte 2 wird ein Unterdruck erzeugt, mit dem ein auf der Vakuum-Ansaugplatte 2 angeordnetes Substrat festgehalten wird. Weiterhin sind in Figur 1 beispielhaft Ansaugbereiche 7a, 7b gezeigt, die getrennt ansteuerbar sind und die zum Festhalten von Substraten in dem jeweiligen Bereich 7a, 7b dienen. Ansaugbereiche 7a, 7b sind sowohl in ihrer Anzahl als auch in ihrer Form und Lage auf der Ansaugfläche im Wesentlichen frei definierbar und regelbar. Zur Erkennung von Leerbereichen auf der Ansaugfläche 3, also von Bereichen, auf denen kein Substrat aufliegt, kann - wie hier dargestellt - eine Kamera 13 angeordnet sein, die mit einer nicht gezeigten Regeleinrichtung, bspw. einem Computer, zur Auswertung, zur Abschaltung nicht belegter Bereiche der Vakuum-Ansaugplatte 2 und zur Ansteuerung der mit Substraten belegten Bereiche 7a, 7b verbunden ist. Die Regeleinrichtung kann dabei beispielsweise zur Steuerung der in Fig. 2 beschriebenen Ansaugeinrichtung 9, Verteilungseinrichtung 6, Ansaugimpulseinrichtung 10 und/oder von Schaltventilen 8 ausgebildet sein.

Die Ansaugöffnungen weisen hier bspw. einen Abstand von 10 mm auf und die Ansaugeinrichtung 9 stellt dabei einen Unterdruck bereit derart, dass das Verhältnis aus kumuliertem Druckabfall in von Substraten bedeckten Ansaugdüsen 5, wobei diese insgesamt einen Anteil der Ansaugfläche von ca. 50% überdecken, und kumuliertem Druckabfall aller Ansaugdüsen 5 und Zuleitungen 6a, 6b der Ansaugdüsen bis zur Ansaugeinrichtung 9 20% beträgt. Je nachdem kann die gleiche Haltekraft durch eine entsprechende proportionale Änderung erfolgen, indem bspw. die vierfache Anzahl von Ansaugöffnungen angeordnet wird und durch die Ansaugeinrichtung 9 ein Verhältnis aus kumuliertem Druckabfall in von einem oder mehreren Substraten unbedeckten Ansaugdüsen 5 und kumuliertem Druckabfall aller Ansaugdüsen 5 und Zuleitungen 6a, 6b der Ansaugdüsen bis zur Ansaugeinrichtung 9 von 5% bereitgestellt wird.

Figur 2 zeigt einen Teil eines Querschnitts durch die Haltevorrichtung gemäß einer Ausführungsform der vorliegenden Erfindung.

In Figur 2 ist nun im Wesentlichen im Querschnitt die Vakuum-Ansaugplatte 2 gezeigt. Auf der rechten Seite der Ansaugplatte 2 ist die Ansaugfläche 3 zu sehen wohingegen auf der linken Seite der Ansaugplatte 2 sich eine Auflagefläche 14 zur Auflage der Vakuum-Ansaugplatte 2 auf eine Tragkonstruktion oder ähnlichem befindet. Ausgehend von der linken Seite der Figur 2 ist zunächst schematisch eine Ansaugeinrichtung 9, beispielsweise eine Vakuumpumpe gezeigt, die mit einer Ansaugimpulseinrichtung 10, eine Unterdruckkammer 11 aufweisend, verbunden ist. Weiterhin stromaufwärts der Ansaugimpulseinrichtung 10 ist ein Schaltventil 8 gezeigt, welches zum An- und Abschalten bzw. zur Regelung des Ansaugstroms für bestimmte Ansaugdüsen 5 für den Bereich 7a dient. In Fig. 2 ist beispielhaft lediglich ein Schaltventil 8 gezeigt; es können selbstverständlich mehrere Schaltventile, beispielsweise pro Ansaugdüse oder pro Versorgungsleitung ein Schaltventil angeordnet werden. Es ist ebenso möglich mehrere Versorgungsleitungen 6a oder Ansaugdüsen 5 mittels eines Schaltventils 8 zu regeln.

Stromaufwärts des gezeigten Schaltventils 8 sind Versorgungsleitungen 6a, 6b einer Vakuumverteilungseinrichtung 6 gezeigt. Diese dienen der fluidischen Verbindung der Ansaugdüsen 5 letztendlich mit der Ansaugeinrichtung 9 und sind mit der Unterseite 14 der Vakuum-Ansaugplatte 2 entsprechend verbunden. Die Versorgungsleitungen 6a sind mit Versorgungsleitungen 6b in der Vakuum-Ansaugplatte 2 und diese mit den Ansaugdüsen 5 verbunden. Die Ansaugeinrichtung 9 oder die Ansaugimpulseinrichtung 10 können jeweils auch ausgebildet sein einen zeitweisen Druckluftstoß bereitzustellen. Dies ermöglicht ein einfaches Lösen eines festgehaltenen Substrats durch zeitweise Umkehrung der Luftförderrichtung.

Zur Überwachung des Unterdrucks in den Versorgungsleitungen 6a, 6b ist eine Unterdruckmesseinrichtung 12 und/oder eine Durchflussmesseinrichtung angeordnet, die zur Regelung mit der Ansaugeinrichtung 9, der Ansaugimpulseinrichtung 10 und/oder den Schaltventilen 8 verbunden sein kann. Der Querschnitt der Versorgungsleitungen 6a, 6b wird dabei so gewählt, dass dieser mindestens dem zweifachen, insbesondere mindestens dem dreifachen der damit versorgten kumulierten Querschnittsfläche der Ansaugdüsen 5 des jeweiligen Teilbereichs 7a, 7b entspricht.

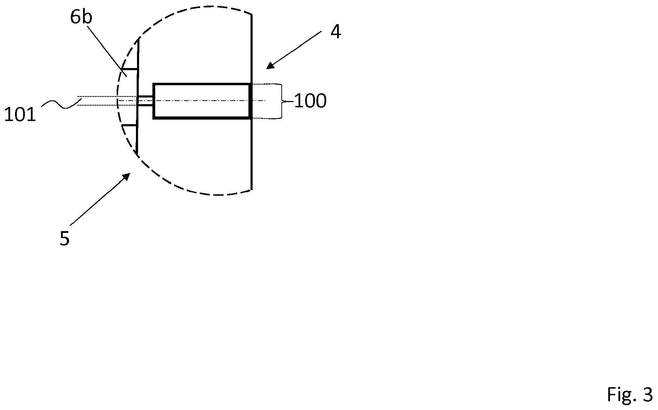

Figur 3 zeigt eine Detailansicht des Querschnitts der Ausführungsform gemäß Figur 2.

In Figur 3 ist nun im Detail eine Ansaugdüse 5 mit angeschlossenen Versorgungsleitungen 6b in der Vakuumansaugplatte 2 gezeigt. Dabei ist das Verhältnis des Durchmessers 100 des Querschnitts der Ansaugöffnung 4 und des Durchmessers des Querschnitts 101 der Ansaugdüse 5 vorzugsweise zwischen 1 und 20, insbesondere zwischen 2 und 12, insbesondere zwischen 5 und 9, vorzugsweise zwischen 6 und 8 gewählt, das Verhältnis der Querschnittsflächen beträgt dann zwischen 0,01 und 10000, vorzugsweise zwischen 1 und 400, insbesondere zwischen 4 und 144, insbesondere zwischen 25 und 81, vorzugsweise zwischen 36 und 64. Der begrenzende Querschnitt der jeweiligen Ansaugdüse 5 führt dabei dazu, dass ein Vakuum-Ansaugstrom bei teilweise offener Oberfläche der Vakuumansaugplatte 2, also mit Bereichen auf denen kein Substrat aufliegt, nicht zusammenbricht, sondern im Wesentlichen konstant bleibt, wobei die Ausbildung des Querschnitts der Ansaugöffnungen 4 zur Erzeugung der notwendigen Haltekraft nach dem Ansaugen dient. Mit anderen Worten: Ist die Querschnittsfläche der Ansaugöffnung geeignet groß, insbesondere größer als die Querschnittsfläche der Ansaugdüse, liegt an ersterer der Differenzdruck an. Dies ist vorteilhaft, denn die Haltekraft für ein Substrat ist im Wesentlichen proportional zum Differenzdruck der Ansaugöffnung zum Umgebungsdruck und der Querschnittsfläche der Ansaugöffnung.

Die Ansaugöffnung 4 kann dabei Teil der Ansaugdüse 5 sein oder auch separat ausgebildet sein, in dem die Ansaugdüse 5 mit der Ansaugöffnung 4 verbunden wird. Die Querschnittsform der Ansaugöffnung 4 und/oder der Ansaugdüse 5 kann dabei insbesondere zylindrisch oder elliptisch ausgebildet sein. Die Herstellung der Ansaugdüse 5 mit Ansaugöffnung 4 kann dabei mittels einer Bohrung mit einer Bohrspitze und/oder mit einer Fase erfolgen.

Die Ansaugdüse kann dabei in Form einer kleinen Bohrung oder Öffnung mit wenigen Millimeter Länge ausgebildet sein. Alternativ oder zusätzlich kann die Bohrung oder Öffnung durch eine Folie, insbesondere eine Metallfolie, ersetzt oder ergänzt sein, welche zwischen Verteilungseinrichtung und Ansaugöffnungen angeordnet sein kann und welche eine oder mehrere Bohrungen noch kleineren Querschnitts aufweist. Eine Verbindung zwischen Öffnung der Ansaugdüse und Ansaugöffnung kann trichterförmig ausgebildet sein, d.h. die Ansaugöffnung läuft konisch zu einer Ansaugdüsengeometrie zu. Ebenso kann eine poröse Folie als Öffnung für die Ansaugdüse verwendet werden. Weiterhin kann die Geometrie der Ansaugdüse(n) geeignet ausgestaltet werden, beispielsweise kreisrund, rechteckig, elliptisch oder dergleichen.

Zusammenfassend kann die Erfindung und insbesondere zumindest eine der Ausführungsformen folgende Vorteile bereitstellen oder diese ermöglichen:
- Zuverlässigeres Festhalten von Substraten
- einfachere Festlegung/Festhalten von Substraten
- geringere Kosten
- hohe Effizienz
- geringer Aufwand
- hohe Prozesssicherheit
- hohe Flexibilität

Die Erfindung kann insbesondere in den Bereichen in Ink-Jet-Druck, Laserbearbeitung, Laserstrukturierung verwendet werden als auch zum Vermessen von Substraten mittels Messsystemen, beispielsweise Kamerasystemen zur Fehlerdetektion auf Substraten, Substrattransport, etc.

Obwohl die vorliegende Erfindung anhand bevorzugter Ausführungsbeispiele beschrieben wurde, ist sie nicht darauf beschränkt, sondern auf vielfältige Weise modifizierbar.

### Bezugszeichenliste

- 1: Haltevorrichtung
- 2: Ansaugplatte
- 3: Ansaugfläche
- 4: Ansaugöffnung
- 5: Ansaugdüse
- 6: Verteilungseinrichtung
- 6a, 6b: Versorgungsleitungen
- 7a, 7b: Ansaugbereiche
- 8: Schaltventil
- 9: Ansaugeinrichtung
- 10: Ansaugimpulseinrichtung
- 11: Unterdruckkammer
- 12: Unterdruckmesseinrichtung
- 13: Erkennungseinrichtung
- 100: Querschnitt der Ansaugöffnungen
- 101: Querschnitt der Ansaugdüsen

## Patentansprüche

1. Haltevorrichtung (1) zum Halten von Substraten wie Leiterplatten, Metallblechen, Folien oder dergleichen,
umfassend
eine Ansaugfläche (3), wobei die Ansaugfläche (3) eine Vielzahl von Ansaugdüsen (5) aufweist und wobei die Ansaugdüsen (5) mit einem Unterdruck gegenüber dem Umgebungsdruck mittels einer Unterdruckbereitstellungseinrichtung (6, 9) zur Bereitstellung einer Haltekraft für ein oder mehrere Substrate beaufschlagbar sind, **dadurch gekennzeichnet, dass**
die Unterdruckbereitstellungseinrichtung (6, 9) einen Unterdruck derart bereitstellt,
dass das Verhältnis aus kumuliertem Druckabfall aller Ansaugdüsen (5) und kumuliertem Druckabfall aller Ansaugdüsen (5) und Zuleitungen (6a, 6b) der Ansaugdüsen bis zur Unterdruckbereitstellungseinrichtung (6, 9) größer als 25%, insbesondere größer als 35%, vorzugsweise größer als 40%.

2. Haltevorrichtung gemäß Anspruch 1, **dadurch gekennzeichnet, dass** zumindest eine der Ansaugdüsen (5) eine Ansaugöffnung (4) aufweist, derart, dass eine Querschnittsfläche der Ansaugöffnung (4) größer ist, als die Querschnittsfläche der Ansaugdüse (5), insbesondere wobei das Verhältnis der Querschnittsfläche (100) der Ansaugöffnungen (4) und Querschnittfläche (101) der Ansaugdüsen (5) zwischen 0,01 und 10000, vorzugsweise zwischen 1 und 400, insbesondere zwischen 4 und 144, insbesondere zwischen 25 und 81, vorzugsweise zwischen 36 und 64 beträgt.

3. Haltevorrichtung gemäß einem der Ansprüche 1-2, **dadurch gekennzeichnet, dass** die Unterdruckbereitstellungseinrichtung (6, 9) eine Verteilungseinrichtung (6) zum Verteilen eines Ansaugstroms auf die Ansaugdüsen (5) umfasst, insbesondere wobei mittels der Verteilungseinrichtung (6) mehrere Ansaugbereiche (7a, 7b) der Ansaugplatte (2) definierbar und getrennt ansteuerbar sind.

4. Haltevorrichtung gemäß Anspruch 3, **dadurch gekennzeichnet, dass** die Verteilungseinrichtung (6) ein oder mehrere Zuleitungen (6a, 6b) zur Versorgung der Ansaugdüsen (5) der Ansaugfläche (3) oder von einem oder mehreren Ansaugbereichen (7a, 7b) aufweist, wobei für die Ansaugfläche (3) oder für jeden Ansaugbereich (7a, 7b) das Verhältnis aus kumulierter Querschnittsfläche der jeweiligen Zuleitungen (6a, 6b) und kumulierter Querschnittsfläche der Ansaugdüsen (5) in der Ansaugfläche (3) oder in dem Ansaugbereich (7a, 7b) mindestens 0,3, vorzugsweise zwischen 1 und 20, insbesondere zwischen 1,5 und 6 beträgt.

5. Haltevorrichtung gemäß einem der Ansprüche 3-4, **dadurch gekennzeichnet, dass** die Verteilungseinrichtung (6) Schaltventile (8) aufweist zum Ansteuern verschiedener Ansaugbereiche (7a, 7b), insbesondere wobei die Unterdruckbereitstellungseinrichtung (6, 9) eine Ansaugimpulseinrichtung (10) aufweist, insbesondere welche strömungstechnisch zwischen einer Ansaugeinrichtung (9) und der Verteilungseinrichtung (6) angeordnet ist zur Bereitstellung eines ersten Ansaugimpulses, insbesondere wobei die Ansaugimpulseinrichtung (10) eine Unterdruckkammer (11) aufweist.

6. Haltevorrichtung gemäß einem der Ansprüche 1-5, **dadurch gekennzeichnet, dass** eine Unterdruckmesseinrichtung (12) und/oder eine Durchflussmesseinrichtung zur Messung des Durchflusses durch die Zuleitungen (6a, 6b) angeordnet ist zur Messung und Regelung eines Unterdrucks des Ansaugstroms, insbesondere wobei ein Unterdruck verschiedener Ansaugbereiche (7a, 7b) mittels der Unterdruckmesseinrichtung (12) und/oder mittels der Durchflussmesseinrichtung messbar und regelbar ist.

7. Haltevorrichtung gemäß einem der Ansprüche 1-6, **dadurch gekennzeichnet, dass** eine Erkennungseinrichtung (13) angeordnet ist zur Erkennung von Leerbereichen der Ansaugplatte (2), die substratfrei sind, insbesondere wobei die Erkennungseinrichtung (13) optische und/oder akustische Erkennungsmittel umfasst.

8. Haltevorrichtung gemäß Anspruch 2 und 7, **dadurch gekennzeichnet, dass** die Erkennungseinrichtung (13) mit der Verteilungseinrichtung (6) verbunden ist, derart, dass bei einem Erkennen von Leerbereichen diese mittels der Verteilungseinrichtung (6) abschaltbar sind.

9. Haltevorrichtung gemäß einem der Ansprüche 1-8, **dadurch gekennzeichnet, dass** die Ansaugdüsen und/oder die Ansaugöffnungen regelmäßig, insbesondere periodisch, verteilt angeordnet sind.

10. Haltevorrichtung gemäß Anspruch 9, **dadurch gekennzeichnet, dass** im Wesentlichen benachbarte Reihen von Ansaugdüsen und/oder Ansaugöffnungen versetzt zueinander angeordnet sind und/oder eine andere Ausbildung aufweisen.

11. Haltevorrichtung gemäß Anspruch 9-10, **dadurch gekennzeichnet, dass** im Randbereich der Ansaugfläche die Ansaugdüsen und/oder die Ansaugöffnungen eine andere Anordnungsdichte und/oder Ausbildung aufweisen.

12. Haltevorrichtung gemäß Anspruch 3, **dadurch gekennzeichnet, dass** verschiedene Ansaugbereiche unterschiedliche angeordnete und/oder ausgebildete Ansaugdüsen und/oder Ansaugöffnungen aufweisen.

13. Haltevorrichtung gemäß einem der Ansprüche 3 oder 12, **dadurch gekennzeichnet, dass** die verschiedenen Ansaugbereiche zum Halten verschieden fester und/oder verschieden dicker Substrate ausgebildet sind.

14. Verfahren zum Halten von Substraten wie Leiterplatten, Metallblechen, Folien oder dergleichen,
wobei ein oder mehrere Substrate mittels einer Ansaugfläche (3) gehalten werden, wobei die Ansaugfläche (3) eine Vielzahl von Ansaugdüsen (5) aufweist, und wobei die Ansaugdüsen (5) mit einem Unterdruck gegenüber dem Umgebungsdruck zur Bereitstellung einer Haltekraft für ein oder mehrere Substrate beaufschlagt werden, **dadurch gekennzeichnet, dass**
mittels einer Unterdruckbereitstellungseinrichtung ein Unterdruck bereitgestellt wird, derart, dass das Verhältnis aus kumuliertem Druckabfall aller Ansaugdüsen (5) und kumuliertem Druckabfall aller Ansaugdüsen (5) und Zuleitungen (6a, 6b) der Ansaugdüsen bis zur Unterdruckbereitstellungseinrichtung (6, 9) größer als 25%, insbesondere größer als 35%, vorzugsweise größer als 40%.

15. Ink-Jet-Druckvorrichtung mit einer Haltevorrichtung gemäß einem der Ansprüche 1-13.

## Claims

1. Retention device (1) for retaining substrates such as printed circuit boards, metal sheets, films or the like, comprising
a suction face (3), wherein the suction face (3) has a large number of suction nozzles (5), and wherein the suction nozzles (5) can be acted on with a reduced pressure compared with ambient pressure by means of a reduced pressure provision device (6, 9) in order to provide a retention force for one or more substrates, **characterised in that** the reduced pressure provision device (6, 9) provides such a reduced pressure that the ratio of the cumulative pressure drop of all the suction nozzles (5) and the cumulative pressure drop of all the suction nozzles (5) and supply lines (6a, 6b) of the suction nozzles as far as the reduced pressure provision device (6, 9) is greater than 25%, in particular greater than 35%, preferably greater than 40%.

2. Retention device according to claim 1, **characterised in that** at least one of the suction nozzles (5) has a suction opening (4) such that a cross-sectional surface-area of the suction opening (4) is greater than the cross-sectional surface-area of the suction nozzle (5), in particular wherein the ratio of the cross-sectional surface-area (100) of the suction openings (4) and cross-sectional surface-area (101) of the suction nozzles (5) is between 0.01 and 10,000, preferably between 1 and 400, in particular between 4 and 144, in particular between 25 and 81, preferably between 36 and 64.

3. Retention device according to either claim 1 or claim 2, **characterised in that** the reduced pressure provision device (6, 9) comprises a distribution device (6) for distributing a suction flow over the suction nozzles (5), in particular wherein by means of the distribution device (6) a plurality of suction regions (7a, 7b) of the suction plate (2) can be defined and can be controlled separately.

4. Retention device according to claim 3, **characterised in that** the distribution device (6) has one or more supply lines (6a, 6b) for supplying the suction nozzles (5) of the suction face (3) or one or more suction regions (7a, 7b), wherein for the suction face (3) or for each suction region (7a, 7b) the ratio of the cumulative cross-sectional surface-area of the respective supply lines (6a, 6b) and cumulative cross-sectional surface-area of the suction nozzles (5) in the suction face (3) or in the suction region (7a, 7b) is at least 0.3, preferably between 1 and 20, in particular between 1.5 and 6.

5. Retention device according to either claim 3 or 4, **characterised in that** the distribution device (6) has switching valves (8) for controlling different suction regions (7a, 7b), in particular wherein the reduced pressure provision device (6, 9) has a suction pulse device (10) which is arranged in particular in technical flow terms between a suction device (9) and the distribution device (6) for providing a first suction pulse, in particular wherein the suction pulse device (10) has a reduced pressure chamber (11).

6. Retention device according to any one of claims 1 to 5, **characterised in that** a reduced pressure measurement device (12) and/or a throughflow measurement device for measuring the throughflow through the supply lines (6a, 6b) is arranged for measuring and controlling a reduced pressure of the suction flow, in particular wherein a reduced pressure of different suction regions (7a, 7b) can be measured and controlled by means of the reduced pressure measurement device (12) and/or by means of the throughflow measurement device.

7. Retention device according to any one of claims 1 to 6, **characterised in that** an identification device (12) is arranged to identify empty regions of the suction plate (2) which are substrate-free, in particular wherein the identification device (13) comprises optical and/or acoustic identification means.

8. Retention device according to claim 2 and claim 7, **characterised in that** the identification device (13) is connected to the distribution device (6) in such a manner that, when empty regions are identified, they can be switched off by means of the distribution device (6).

9. Retention device according to any one of claims 1 to 8, **characterised in that** the suction nozzles and/or the suction openings are arranged in a state distributed in a regular, in particular periodic manner.

10. Retention device according to claim 9, **characterised in that** substantially adjacent rows of suction nozzles and/or suction openings are arranged in an offset manner with respect to each other and/or have a different construction.

11. Retention device according to claims 9 and 10, **characterised in that** in the edge region of the suction face the suction nozzles and/or the suction openings have a different arrangement density and/or construction.

12. Retention device according to claim 3, **characterised in that** different suction regions have different arranged and/or constructed suction nozzles and/or suction openings.

13. Retention device according to either claim 3 or claim 12, **characterised in that** the different suction regions are constructed to retain substrates of different strengths and/or different thicknesses.

14. Method for retaining substrates such as printed circuit boards, metal sheets, films or the like,
wherein one or more substrates are retained by means of a suction face (3), wherein the suction face (3) has a large number of suction nozzles (5) and wherein the suction nozzles (5) are acted on with a reduced pressure compared with ambient pressure in order to provide a retention force for one or more substrates, **characterised in that** using a reduced pressure provision device a reduced pressure is provided such that the ratio of the cumulative pressure drop of all the suction nozzles (5) and the cumulative pressure drop of all the suction nozzles (5) and supply lines (6a, 6b) of the suction nozzles as far as the reduced pressure provision device (6, 9) is greater than 25%, in particular greater than 35%, preferably greater than 40%.

15. Ink-jet printing device having a retention device according to any one of claims 1 to 13.

## Revendications

1. Dispositif de maintien (1) pour le maintien de substrats comme des circuits imprimés, des tôles métalliques, des films ou autres,
comprenant
une surface d'aspiration (3), dans lequel la surface d'aspiration (3) comprend une pluralité de buses d'aspiration (5) et dans lequel les buses d'aspiration (5) peuvent être alimentées avec une dépression par rapport à la pression ambiante au moyen d'un dispositif de mise à disposition de dépression (6, 9) pour la mise à disposition d'une force de maintien pour un ou plusieurs substrats,
**caractérisé en ce que**
le dispositif de mise à disposition de dépression (6, 9) génère une dépression de façon à ce que le rapport entre la chute de pression cumulée de toutes les buses d'aspiration (5) et la chute de pression cumulée de toutes les buses d'aspiration (5) et des conduites d'alimentation (6a, 6b) des buses d'aspiration jusqu'au dispositif de mise à disposition de dépression (6, 9) est supérieur à 25 %, plus particulièrement supérieur à 35 %, de préférence supérieur à 40 %.

2. Dispositif de maintien selon la revendication 1, **caractérisé en ce qu'**au moins une des buses d'aspiration (5) comprend une ouverture d'aspiration (4) de façon à ce qu'une surface de section transversale de l'ouverture d'aspiration (4) soit supérieure à la surface de section transversale de la buse d"aspiration (5), plus particulièrement dans lequel le rapport entre la surface de section transversale (100) des ouvertures d'aspiration (4) et la surface de section transversale (101) des buses d'aspiration (5) est entre 0,1 et 10000, de préférence entre 1 et 400, plus particulièrement entre 4 et 44, plus particulièrement entre 25 et 81, de préférence entre 36 et 64.

3. Dispositif de maintien selon l'une des revendications 1 - 2, **caractérisé en ce que** le dispositif de mise à disposition de dépression (6, 9) comprend un dispositif de répartition (6) pour la répartition d'un flux d'aspiration entre les buses d'aspiration (5), plus particulièrement dans lequel le dispositif de répartition (6) permet de définir et de contrôler séparément plusieurs zones d'aspiration (7a, 7b) de la plaque d'aspiration (2).

4. Dispositif de maintien selon la revendication 3, **caractérisé en ce que** le dispositif de répartition (6) comprend une ou plusieurs conduites d'alimentation (6a, 6b) pour l'alimentation des buses d'aspiration (5) de la surface d'aspiration (3) ou d'une ou plusieurs zones d'aspiration (7a, 7b), dans lequel, pour la surface d'aspiration (3) ou pour chaque zone d'aspiration (7a, 7b), le rapport entre la surface de section transversale cumulée des conduites d'alimentation (6a, 6b) respective et la surface de section transversale cumulée des buses d'aspiration (5) dans la surface d'aspiration (3) ou dans la zone d'aspiration (7a, 7b) est d'au moins 0,3, de préférence entre 1 et 20, plus particulièrement entre 1,5 et 6.

5. Dispositif de maintien selon l'une des revendications 3 - 4, **caractérisé en ce que** le dispositif de répartition (6) comprend des soupapes de commutation (8) pour le contrôle de différentes zones d'aspiration (7a, 7b), plus particulièrement dans lequel le dispositif de mise à disposition de dépression (6, 9) comprend un dispositif d'aspiration par impulsions (10), plus particulièrement celui-ci étant disposé, en termes d'écoulement, entre un dispositif d'aspiration (9) et le dispositif de répartition (6) pour la mise à disposition d'une première impulsion d'aspiration, plus particulièrement dans lequel le dispositif d'aspiration par impulsions (10) comprend une chambre de dépression (11).

6. Dispositif de maintien selon l'une des revendications 1 - 5, **caractérisé en ce qu'**un dispositif de mesure de dépression (12) et/ou un dispositif de mesure de débit pour la mesure du débit à travers les conduites d'alimentation (6a, 6b), pour la mesure et la régulation d'une dépression du flux d'aspiration, plus particulièrement dans lequel une dépression de différentes zones d'aspiration (7a, 7b) peut être mesurée et régulée au moyen du dispositif de mesure de dépression (12) et/ou au moyen du dispositif de mesure de débit.

7. Dispositif de maintien selon l'une des revendications 1 - 6, **caractérisé en ce qu'**un dispositif de détection (13) est disposé pour la détection de zones vides de la plaque d'aspiration (2) qui sont exemptes de substrat, plus particulièrement dans lequel le dispositif de détection (13) comprend des moyens de détection optiques et/ou acoustiques.

8. Dispositif de maintien selon la revendication 2 et 7, **caractérisé en ce que** le dispositif de détection (13) est relié avec le dispositif de répartition (6), de façon à ce que, lors de la détection de zones vides, celles-ci puissent être désactivées au moyen du dispositif de répartition (6).

9. Dispositif de maintien selon l'une des revendications 1 - 8, **caractérisé en ce que** les buses d'aspiration et/ou les ouvertures d'aspiration sont réparties de manière régulière, plus particulièrement de manière périodique.

10. Dispositif de maintien selon la revendication 9, **caractérisé en ce que**, des rangées globalement adjacentes de buses d'aspiration et/ou d'ouvertures d'aspiration sont disposées de manière décalée entre elles et/ou présentent une autre disposition.

11. Dispositif de maintien selon la revendication 9 - 10, **caractérisé en ce que**, sur le bord de la surface d'aspiration, les buses d'aspiration et/ou les ouvertures d'aspiration présentent une autre densité de disposition et/ou une autre disposition.

12. Dispositif de maintien selon la revendication 3, **caractérisé en ce que** différentes zones d'aspiration comprennent des buses d'aspiration et/ou ouvertures d'aspiration disposées et/ou conçues de manières différentes.

13. Dispositif de maintien selon l'une des revendications 3 ou 12, **caractérisé en ce que** les différentes zones d'aspiration sont conçues pour le maintien de substrats de différentes solidités et/ou de différentes épaisseurs.

14. Procédé de maintien de substrat comme des circuits imprimés, des tôles métalliques, des films ou autres,
dans lequel un ou plusieurs substrats sont maintenus au moyen d'une surface d'aspiration (3), dans lequel la surface d'aspiration (3) comprend une pluralité de buses d'aspiration (5) et dans lequel les buses d'aspiration (5) sont alimentées avec une dépression par rapport à la pression ambiante pour la mise à disposition d'une force de maintien pour un ou plusieurs substrats,
**caractérisé en ce que**
un dispositif de mise à disposition de dépression permet de fournir une dépression de façon à ce que le rapport entre la chute de pression cumulée de toutes les buses d'aspiration (5) la chute de pression cumulée de toutes les buses d'aspiration (5) et des conduites d'alimentation (6a, 6b) des buses d'aspiration jusqu'au dispositif de mise à disposition de dépression (6, 9) est supérieur à 25 %, plus particulièrement supérieur à 35 %, de préférence supérieur à 40 %.

15. Dispositif d'impression à jet d'encre avec un dispositif de maintien selon l'une des revendications 1 - 13.
